# EUROPEAN PATENT SPECIFICATION

(11) **EP 0 434 218 B1**
(45) Date of publication and mention of the grant of the patent: **01.06.1994**
(21) Application number: 90312617.5
(22) Date of filing: 20.11.1990
(51) Int. Cl.: H01L 31/107, H01L 31/0304

(54) **Semiconductor photodetection device**
Halbleiterfotodetektorvorrichtung
Dispositif photodétecteur à semi-conducteurs

(30) Priority: 20.11.1989 JP 301064/89
(43) Date of publication of application: 26.06.1991
(73) Proprietor: FUJITSU LIMITED, Kawasaki-shi, Kanagawa 211 (JP)
(72) Inventor: Shirai, Tatsunori, Yokohama-shi, Kanagawa, 240 (JP)
(74) Representative: Fenlon, Christine Lesley

(56) References cited:
- EP-A- 0 001 139
- EP-A- 0 108 561
- EP-A- 0 304 048
- PATENT ABSTRACTS OF JAPAN vol. 11, no. 108 (E-495)(2555) 04 April 1987, & JP-A-61 256771
- PATENT ABSTRACTS OF JAPAN vol. 11, no. 119 (E-499)(2566) 14 April 1987, & JP-A-61 267376

## Description

### BACKGROUND OF THE INVENTION

The present invention generally relates to semiconductor devices and more particularly to a semiconductor photodetection device using a compound semiconductor material.

Semiconductor photodetection devices are used in various technical fields such as optical telecommunication. Particularly, the devices that are formed on the compound semiconductor materials such as InP, InGaAs, and the like, play a major role in the advanced optical telecommunication system. Among various semiconductor photodetection devices, the avalanche photodiode (APD) using InGaAs is particularly important for the long distance optical telecommunication trunks because of the excellent sensitivity.

In the avalanche photodiodes, a member called guard ring is used in correspondence to a surface electrode for sustaining a large bias voltage applied to the surface electrode for causing the avalanche multiplication of the carriers.

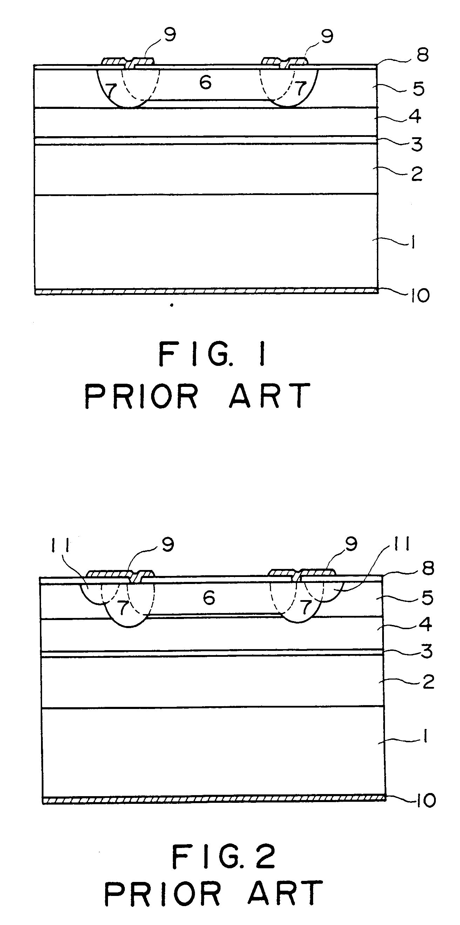

FIG.1 shows a conventional avalanche photodiode.

Referring to FIG.1, the avalanche photodiode is constructed on a n⁺-type InP substrate 1. More specifically, there is formed an optical absorption layer 2 of n-type InGaAs on the substrate 1, and an intermediate layer 3 of n-type InGaAsP is provided on the optical absorption layer 2. Further, a n-type InP avalanche multiplication layer 4 is provided on the intermediate layer 3, and a n⁻-type InP layer 5 having an impurity concentration level different from that of the layer 4 is provided on the avalanche multiplication layer 4. In a part of the InP layer 5, there is provided a p⁺-type InP region 6 forming a window for receiving optical radiation. Thereby, there is formed a p-n junction at an interface between the InP region 6 and the rest of the InP layer 5.

Around the InP region 6, there is formed a guard ring 7 for ensuring that the avalanche photomultiplication occurs at the p-n junction formed between the region 6 and the layer 5, and the entire structure is protected by a silicon nitride passivation film 8 that covers the upper surface of the InP layer 5. Further, in correspondence to the guard ring 7, there is provided an electrode 9 on the passivation film 8 in electrical contact with the guard ring 7. Furthermore, an opposing electrode 10 is provided at a bottom surface of the substrate 1.

In operation, a large bias voltage is applied across the electrode 9 and the electrode 10 such that the p-n junction at interface between the p⁺-type region 6 and the n⁻-type InP layer 5 is reverse biased. Upon incidence of optical radiation through the region 6, the photons of the optical radiation are absorbed by the optical absorption layer 2 and thereby the electrons and holes are formed in the layer 2. The holes then migrate into the region 6 and collected by the electrode 9, while the electrons are collected by the electrode 10 after passing through the substrate 1. As there is established a large electric field in the p-n junction between the region 6 and the layer 5, the holes that entered into the n-region 4 are accelerated and thereby the multiplication of the electrons and holes occurs by the avalanche effect.

It should be noted that the guard ring 7 is provided such that the concentration of the electric field at the outer edge of the p⁺-region 6 is avoided and the avalanche multiplication occurs always at the p-n junction formed at the central part of the region 6. In the illustrated example, the impurity concentration level of the n⁻-type InP layer 5 is decreased such that the lateral spreading of the depletion region formed at the p-n junction is facilitated. Thereby, the concentration of the electric field due to the curvature of the guard ring 7 is relaxed and a sufficient breakdown voltage, larger than that of the region 6, is obtained for the guard ring 7 with respect to the n⁻-type InP layer 5.

FIG.2 shows another conventional example. In this structure, there is provided a second, shallow guard ring 11 at the outside of the guard ring 7 for further relaxation of the electric field concentration.

In any of the foregoing examples, it is necessary to increase the impurity concentration level of the n-type avalanche multiplication layer 4 in order to achieve an improved response of the avalanche photodiode. Such a requirement of the improved response is particularly acute in the devices that are used in the optical telecommunications. However, the increase in the impurity concentration level of the layer 4 invites a decrease in the breakdown voltage between the guard ring 7 and the n⁻-type InP region 5. For example, when the layer 4 is doped to the impurity concentration level of 5 X 10¹⁶cm⁻³, the breakdown voltage of the guard ring 7 is decreased to about 50 - 60 volts. This breakdown voltage is substantially equal to or smaller than the breakdown voltage of about 60 volts of the p⁺-type region 6, and thus, the avalanche photodiode does not operate properly.

### SUMMARY OF THE INVENTION

Accordingly, it is a general object of the present invention to provide a novel and useful avalanche photodiode wherein the foregoing problems are eliminated.

Another and more specific object of the present invention is to provide an avalanche photodiode having an improved response.

Another object of the present invention is to provide an avalanche photodiode wherein a sufficient breakdown voltage is secured for the guard ring even when the impurity concentration level is increased in the n-type InP avalanche multiplication layer.

Another object of the present invention is to provide an avalanche photodiode comprising a semiconductor substrate of a first conductivity type, a first compound semiconductor layer of the first conductivity type provided on the semiconductor substrate for absorbing optical radiation incident to the avalanche photodiode and having a first band gap, a second compound semiconductor layer of the first conductivity type provided on the first compound semiconductor layer and having a second band gap that is larger than the first band gap, a photoreception region of a second conductivity type opposite from the first conductivity type formed in the second compound semiconductor layer, and a guard ring region of the second conductivity type formed to surround the photoreception region along a boundary thereof, said second compound semiconductor layer comprising a first layer having a first impurity concentration level, a second layer having a second impurity concentration level that is larger than the first impurity concentration level and provided on the first layer for inducing avalanche multiplication of carriers, and a third layer having a third impurity concentration level that is smaller than the second impurity concentration level and provided on the second layer, wherein the guard ring is formed such that the guard ring extends into the second layer passing through the third layer. According to the present invention, a sufficient breakdown voltage exceeding 100 volts is achieved for the guard ring. This is due to the finding of the applicant that forms the basis of the present invention that the breakdown voltage of the guard ring increases with decreasing distance between the deepest level of the guard ring and the top surface of the first layer. The guard ring may even contact or penetrate through the top surface of the first layer. Thereby, one can increase the impurity concentration level of the first layer acting as the avalanche multiplication layer without degrading the breakdown voltage of the guard ring and the response of the avalanche photodiode is improved.

Other objects and further features of the present invention will become apparent from the following detailed description when read in conjunction with the attached drawings.

### BRIEF DESCRIPTION OF THE DRAWINGS

FIG.1 is a diagram showing the structure of a conventional avalanche photodiode;
FIG.2 is a diagram showing the structure of another conventional avalanche photodiode;
FIG.3 is a diagram showing the structure of an avalanche photodiode according to an example of the present invention;
FIG.4 is a graph showing a relationship between the breakdown voltage of the guard ring and the vertical extension of the guard ring used in the device of FIG.3;
FIG.5 is a diagram showing the discribution of electric potential in the structure of FIG.3;
FIG.6 is a diagram showing the band structure of the optical absorption layer employed in the structure of FIG.3;
FIGS.7A - 7D are diagrams showing the process of forming the avalanche photodiode of FIG.3; and
FIG.8 is a diagram showing the structure of the avalanche photodiode according to a second embodiment of the present invention.

### DETAILED DESCRIPTION

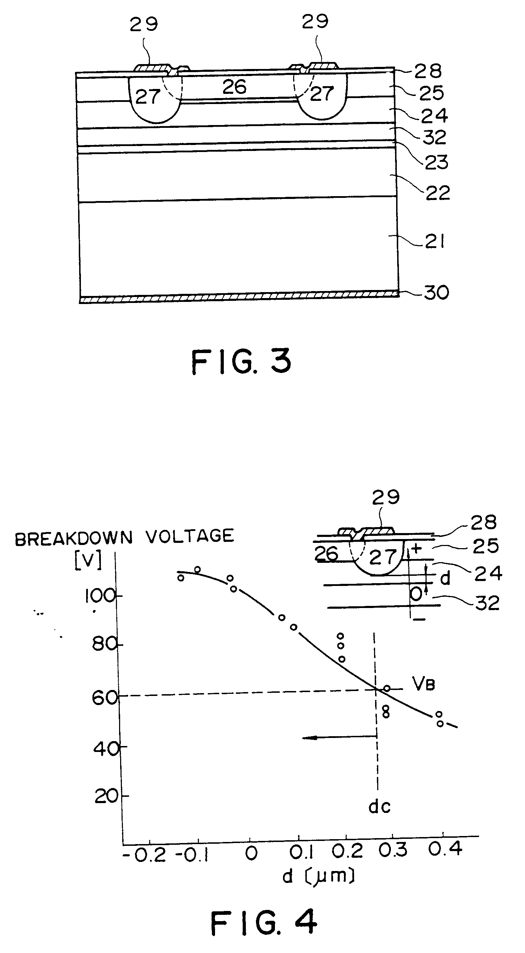

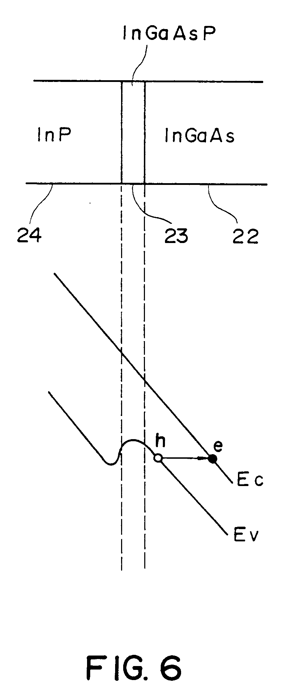

FIG.3 shows a first embodiment of the avalanche photodiode of the present invention.

Referring to FIG.3, the avalanche photodiode is constructed on a n⁺-type InP substrate 21, and there is provided an optical absorption layer 22 of n-type InGaAs having the impurity concentration level of 5 X 10¹⁵cm⁻³ on the substrate 21 with a thickness of 2 µm. Further, an intermediate layer 23 of n-type InGaAsP is formed on the optical absorption layer 22 with a thickness of 0.3 µm. The layer 23 is doped to an impurity concentration level of 5 X 10¹⁵cm⁻³.

On the intermediate layer 23, there is formed a n⁻-type InP layer 32 doped to the impurity concentration level of 5 X 10¹⁵cm⁻³ with a thickness of 0.5 µm, and another InP layer 24 doped to the n-type with the impurity concentration level of 5 X 10¹⁶cm⁻³ is formed with a thickness of 0.5 µm. As will be described later, this layer 24 acts as the avalanche multiplication layer causing the avalanche multiplication of the carriers. Further, another n⁻-type InP layer 25 doped to the impurity concentration level of 5 X 10¹⁵cm⁻³ is formed on the n-type InP layer 24 with a thickness of 1 µm.

In the central part of the layer 25, there is formed a p⁺-type region 26, by the diffusion of Cd for example, to an impurity concentration level of 10¹⁸ cm⁻³. The region 26 may be formed with a diameter of about 100 µm and such that the region 26 extends toward the layer 24 up to the vicinity of the boundary between the layer 24 and the layer 25.

The p⁺-type region 26 is defined laterally by a boundary, and there is formed a guard ring region 27, doped to the p⁺-type by the ion implantation of Be with the impurity concentration level of 1 X 10¹⁶cm⁻³ - 1 X 10¹⁷cm⁻³ such that the guard ring region 27 reaches a depth close to the boundary between the layer 24 and the underlying n -type InP layer 32. In other words, the guard ring region 27 penetrates through the layer 25 and extends into the layer 24. This guard ring region 27 may reach or exceed the boundary between the layer 24 and the layer 32 as will be described later. It should be noted that the guard ring region 27 has a top surface that coincides with the top surface of the InP layer 25.

On the top surface of the InP layer 25, there is provided a passivation film 28 of silicon nitride for protecting the surface, and there the passivation film 28 is patterned to expose the top surface of the guard ring region 27. On the exposed part of the guard ring region 27, there is provided an electrode 29 of gold-Zinc (Au-Zn) layered structure by deposition and patterning. Further, an electrode 30 of gold-germanium (Au-Ge) layered structure is provided on the entire bottom surface of the substrate 21 as an electrode that opposes the electrode 29.

In operation, a reverse bias voltage is applied across the electrode 29 and the electrode 30 such that a depletion region is formed in correspondence to the p-n junction between the p⁺-type region 26 and the n⁻-type layer 25. As usual, the guard ring region 27 eliminates the concentration of the electric field at the boundary or edge of the p⁺-type region 26 and ensures a uniform electric field throughout region 26.

Upon incidence of an optical beam that has a wavelength that interacts with InGaAs forming the optical absorption layer 22, a number of electron-hole pairs are formed upon the absorption of the photons. Thereby, the holes are attracted to the electrode 29 applying a negative voltage while the electrons are attracted to the electrode 30 applying a positive voltage. The holes are then accelerated in the avalanche multiplication layer 24 and thereby a number of electron-hole pairs are created in the layer 24 as a result of the avalanche effect. Because of this multiplication of the carriers, the avalanche photodiode provides an advantageous feature of increased sensitivity and reduced noise.

FIG.4 shows the relationship between the breakdown voltage of the guard ring 27 and the depth of the guard ring 27 measured from the boundary between the layer 32 and the layer 24. This relationship was obtained by preparing a number of samples that have the structure shown in FIG.3 while changing the distance d specified in FIG.3 and by measuring the breakdown voltage of the guard ring region 27.

As can be seen clearly from FIG.4, the breakdown voltage of the guard ring region 27 increases with decreasing distance d, and reaches a maximum somewhere between d = 0 and d = -0.1. In the case of d = 0, the tip of the region 27 reaches the boundary between the layer 24 and the layer 32, while if the parameter d having a negative value, the region 27 extends beyond the boundary into the layer 32. In any way, a breakdown voltage exceeding 70 volts, that is higher than the breakdown voltage of about 60 volts for the p -type region 26, is obtained when the distance d is set to about 0.2 µm or smaller. Generally, the parameter d is set smaller than a value d_{c} shown in FIG.4 wherein the breakdown voltage of the guard ring 27 is coincident to the breakdown voltage V_{B} of the region 26.

When the breakdown voltage of the impurity concentration level of the guard ring region 27 is increased as such, the impurity concentration level of the avalanche multiplication layer 24 can be increased and the response of the device is improved. It should be noted that the impurity concentration level of the layer 24 has conventionally been limited to 2 - 3 X 10¹⁶cm⁻³ because of the breakdown of the guard ring.

Next, another feature of the present invention with respect to the n -type layer 32 that is used in combination of the guard ring region 27 will be described.

The lightly doped n⁻-type InP layer 32 is interposed between the layer 24 and the intermediate layer 33 for reducing the electric field applied to the part of the InGaAs optical absorption layer 24 adjacent to the intermediate layer 23. It should be noted that the heavily doped guard ring region 27 extending deeply into the layer 24 and reaching the vicinity of the interface between the layer 24 and the layer 32 induces an increase in the electric field for those part of the InGaAs optical absorption layer 22 adjacent to the intermediate layer 33.

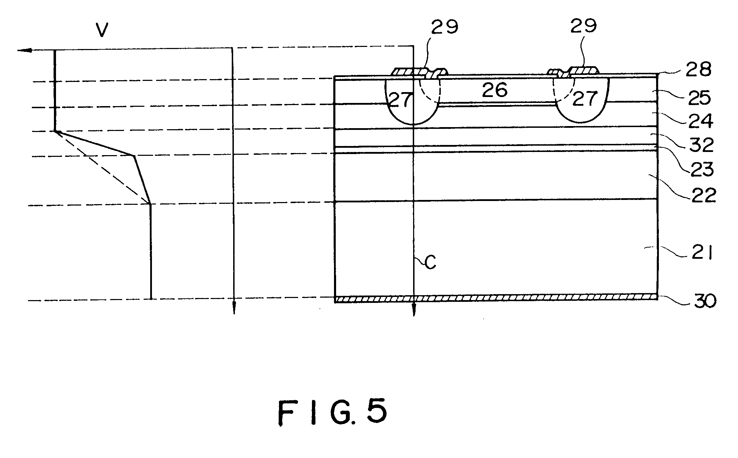

FIG.5 shows, by a broken line, the distribution of the electric potential V in the device when the InP layer 32 is not provided. The profile is taken along a path C passing through the electrode 29 as shown therein. In this case, there appears a steep slope in the distribution showing a large electric field appearing in the region between the guard ring 27 and the substrate 21, including the optical absorption layer 22.

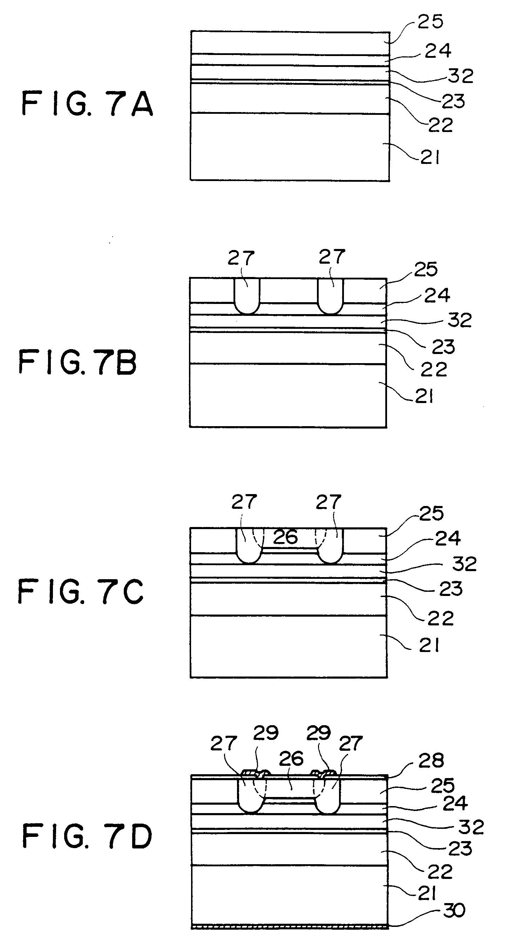

When such a large electric field is applied to the optical absorption layer, there is a chance that tunnel electrons flow within the region 22 by causing a transition from the valence band Ev to the conduction band Ec as shown in FIG.6. Such a tunnel current flows irrespective of whether there is an incidence of the optical beam to the device or not and forms the dark current or noise. In the present invention, the large electric field in the optical absorption layer 22 is relaxed by interposing the less conductive InP layer 32 between the layer 23 and the layer 24 as illustrated by the solid line in FIG.5. Such a large electric field applied to the InP layer 32 does not cause the transition of the tunnel electrons as InP has a band gap of 1.34 eV that is substantially larger than the band gap of 0.75 eV of InGaAs. Of course, when the profile of FIG.5 is taken along a path passing through the center of the region 26, there appears a slope in the distribution of the electric potential in the layer 24 indicating that there is an electric field that causes the avalanche multiplication of the carriers.

Next, the process of producing the structure of FIG.3 will be described with reference to FIGS.7A - 7D.

In a first step of FIG.7A, the InGaAs optical absorption layer 22 is grown epitaxially on the InP substrate 21 with the thickness of 2 µm. As already described, the InP substrate 21 is doped to the n⁺-type and the layer 22 is doped to the n-type with the impurity concentration level of 5 X 10¹⁵cm⁻³. Further, the n-type InGaAsP intermediate layer 23 is grown on the layer 22 with the thickness of 0.3 µm and the impurity concentration level of 5 X 10¹⁵cm⁻³. Further, the n⁻-type InP first bottom layer 32, the n-type InP second middle layer 24 and the n-type InP third upper layer 25 are grown successively on the layer 23 respectively with the thickness of 0.5 µm, 0.5 µm and 1 µm. As already described, the impurity concentration levels of the layers 32, 24 and 25 are 5 X 10¹⁵cm⁻³, 5 X 10¹⁶cm⁻³ and 5 X 10¹⁵cm⁻³, respectively.
Thereby, the structure shown in FIG.7A is obtained.

Next, the structure of FIG.7A is subjected to an ion implantation process of Be carried out under an acceleration voltage of 150 eV and a dose of 5 X 10¹³cm⁻². After the ion implantation, the structure is subjected to an annealing process at 750 °C for 30 minutes. With this process, the implanted Be atoms are driven in and the guard ring region 27 is formed with the thickness of about 1.5 µm. Thereby, the lower end of the region 27 reaches the boundary between the layer 32 and the layer 24 as shown in FIG.7B.

Next, a silicon nitride film not illustrated is deposited on the surface of the structure of FIG.7B by a plasma chemical vapor deposition process and is patterned subsequently to expose an area of the surface of the layer 25 in correspondence to the region 26. Further, using the patterned silicon nitride film as the mask, Cd is diffused into the layer 25 by a thermal drive-in process undertaken at 550 °C for 20 minutes. Thereby the p⁺-type region 26 is formed with the thickness of about 1 µm as shown in FIG.7C.

After the step of FIG.7C, the patterned silicon nitride film is removed by etching and the passivation film 28 of silicon nitride is deposited on the surface of the layer 25 by the plasma chemical vapor deposition process. The passivation film 28 is then patterned to expose the region of the layer 25 wherein the guard ring region 27 is formed, and in correspondence to the exposed guard ring region 27, the electrode 29 is deposited. Next, the electrode 30 is deposited on the bottom surface of the substrate 21 and the structure of FIG.3 is completed as shown in FIG.7D.

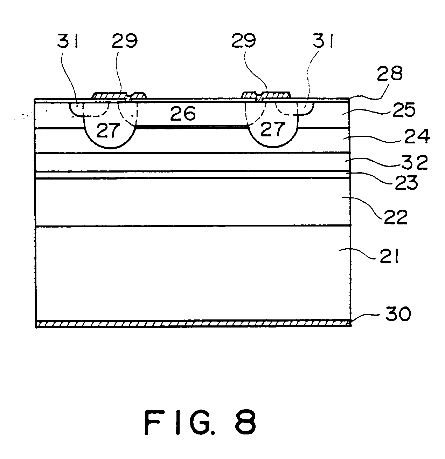

FIG.8 shows a second embodiment of the avalanche photodiode of the present invention. In this embodiment, there is provided a second guard ring 31 at the outer boundary of the guard ring region 27. Thereby, the concentration of the electric field at the guard ring 31 is further relaxed. Other parts of this embodiment are identical with those already described and the description thereof will be omitted.

Further, it should be noted that the present invention is applicable also for the case wherein the conductivity type of each semiconductor layers in the structure is reversed.

## Claims

1. An avalanche photodiode for detecting optical radiation, comprising:
a substrate (21) of a first semiconductor material and having an upper major surface and a lower major surface;
a first semiconductor layer (22) having an upper major surface and a lower major surface and provided on the upper major surface of the substrate, said first semiconductor layer comprising a first group III-V compound semiconductor material doped to a first conductivity type and having a band gap corresponding to a wavelength of the optical radiation to be detected, said first semiconductor layer producing carriers in response to the optical radiation incident to the avalanche photodiode;
a second semiconductor layer (24, 25, 32) having an upper major surface and a lower major surface and provided on the upper major surface of the first semiconductor layer, said second semiconductor layer comprising a second group III-V compound semiconductor material doped to the first conductivity type and having a band gap substantially larger than the band gap of the first semiconductor layer, said second semiconductor layer being supplied with the carriers produced in the first semiconductor layer for causing an avalanche multiplication of the carriers;
a doped photoreception region (26) of the second conductivity type formed within the second semiconductor layer and extending from the upper major surface of the second semiconductor layer into said layer such that its lower major surface is located above the lower major surface of the second semiconductor layer, said photoreception region transmitting the optical beam incident to the avalanche photodiode, said lower major surface of the photoreception region forming a p-n junction between the photoreception region and the second semiconductor layer located underneath;
a doped guard ring region (27) of the second conductivity type extending from the upper major surface of the second semiconductor layer along a lateral boundary of the photoreception region and in continuation therewith into said second semiconductor layer, toward the lower major surface of the second semiconductor layer;
a first electrode (29) provided on the upper major surface of the guard ring region for making an electrical contact therewith; and
a second electrode (30) provided on the lower major surface of the substrate for mating an electrical contact therewith;
said first and second electrodes being adapted, for applying a reverse bias voltage to said p-n junction formed at the lower major surface of the photoreception region and further for collecting the carriers that are formed in response to the optical radiation and the avalanche multiplication;
characterized in that said second semiconductor layer is formed as a stack having a first bottom layer (32), a second middle layer (24) and a third upper layer (25), said first, second and third layers having respective impurity concentration levels such that the impurity concentration levels of the first layer (32) and the third layers (25) are substantially smaller than the impurity concentration level of the second layer (24);
the photoreception region is formed such that the lower major surface thereof is located coincident to or above the lower major surface of the third layer (25); and
the guard ring region is formed at such a depth that the guard ring region extends at least into the second middle layer (24) and a lower boundary of the guard ring region is located below the upper major surface of said second middle layer (24).

2. An avalanche photodiode as claimed in claim 1 characterized in that said first group III-V compound semiconductor material comprises InGaAs and said second group III-V compound semiconductor material comprises InP.

3. An avalanche photodiode as claimed in claim 1 characterized in that said second middle layer (24) of the second semiconductor layer has the impurity concentration level of about 5 X 10¹⁶cm⁻³ or more.

4. An avalanche photodiode as claimed in claim 1 characterized in that said first bottom layer (32) of the second semiconductor layer has the impurity concentration level of about 5 X 10¹⁵cm⁻³.

5. An avalanche photodiode as claimed in claim 1 characterized in that said lower boundary of the guard ring region (27) reaches the lower major surface of the second middle layer (24).

6. An avalanche photodiode as claimed in claim 1 characterized in that said guard ring region (27) extends toward the lower major surface of the second middle layer of the second semiconductor layer such that the separation (d) between the lower boundary of the guard ring region and the lower major surface of the second middle layer (24) is about 0.2 µm or less.

7. An avalanche photodiode as claimed in claim 1 characterized in that said guard ring region (27) extends toward the lower major surface of the second middle layer (24) of the second semiconductor layer and is spaced therefrom by a distance (d) such that the guard ring region has a breakdown voltage that is higher than the breakdown voltage (V_{B}) of the photoreception region (26).

## Patentansprüche

1. Eine Lawinen-Fotodiode zum Detektieren von optischer Strahlung, die umfaßt:
ein Substrat (21) aus einem ersten Halbleitermaterial und mit einer oberen Hauptoberfläche und einer unteren Hauptoberfläche;
eine erste Halbleiterschicht (22), die eine obere Hauptoberfläche und eine untere Hauptoberfläche hat und auf der oberen Hauptoberfläche des Substrats vorgesehen ist, wobei die genannte erste Halbleiterschicht ein Verbindungshalbleitermaterial einer ersten Gruppe III-V umfaßt, das auf einen ersten Leitfähigkeitstyp dotiert ist, und eine Bandlücke hat, die einer Wellenlänge der zu detektierenden optischen Strahlung entspricht, welche erste Halbleiterschicht als Reaktion auf die optische Strahlung, die auf die Lawinen-Fotodiode einfällt, Träger erzeugt;
eine zweite Halbleiterschicht (24, 25, 32), die eine obere Hauptoberfläche und eine untere Hauptoberfläche hat und auf der oberen Hauptoberfläche der ersten Halbleiterschicht vorgesehen ist, wobei die genannte zweite Halbleiterschicht ein Verbindungshalbleitermaterial einer zweiten Gruppe III-V umfaßt, das auf den ersten Leitfähigkeitstyp dotiert ist, und eine Bandlücke hat, die wesentlich größer als die Bandlücke der ersten Halbleiterschicht ist, welcher zweiten Halbleiterschicht die Träger, die in der ersten Halbleiterschicht erzeugt wurden, zum Verursachen einer Lawinenvervielfachung der Träger zugeführt werden;
eine dotierte Fotoempfangszone (26) des zweiten Leitfähigkeitstyps, die innerhalb der zweiten Halbleiterschicht gebildet ist und sich von der oberen Hauptoberfläche der zweiten Halbleiterschicht in die genannte Schicht so erstreckt, daß ihre untere Hauptoberfläche über der unteren Hauptoberfläche der zweiten Halbleiterschicht angeordnet ist, welche Fotoempfangszone den optischen Strahl, der auf die Lawinen-Fotodiode einfällt, hindurchläßt, welche untere Hauptoberfläche der Fotoempfangszone einen p-n-Übergang zwischen der Fotoempfangszone und der zweiten Halbleiterschicht, die darunter angeordnet ist, bildet;
eine dotierte Schutzringzone (27) des zweiten Leitfähigkeitstyps, die sich von der oberen Hauptoberfläche der zweiten Halbleiterschicht längs einer seitlichen Grenze der Fotoempfangszone und in deren Fortsetzung in die genannte zweite Halbleiterschicht hin zu der unteren Hauptoberfläche der zweiten Halbleiterschicht erstreckt;
eine erste Elektrode (29), die auf der oberen Hauptoberfläche der Schutzringzone zum Bilden eines elektrischen Kontaktes mit ihr vorgesehen ist; und
eine zweite Elektrode (30), die auf der unteren Hauptoberfläche des Substrats zum Bilden eines elektrischen Kontaktes mit ihm vorgesehen ist;
welche ersten und zweiten Elektroden zum Anwenden einer Sperrvorspannung auf den genannten p-n-Übergang, der an der unteren Hauptoberfläche der Fotoempfangszone gebildet ist, und ferner zum Sammeln der Träger ausgelegt sind, die als Reaktion auf die optische Strahlung und die Lawinenvervielfachung gebildet werden;
dadurch gekennzeichnet, daß die genannte zweite Halbleiterschicht als Stapel gebildet ist, der eine erste, untere Schicht (32), eine zweite, mittlere Schicht (24) und eine dritte, obere Schicht (25) hat, welche ersten, zweiten und dritten Schichten jeweils solche Verunreinigungskonzentrationsniveaus haben, daß die Verunreinigungskonzentrationsniveaus der ersten Schicht (32) und der dritten Schicht (25) wesentlich kleiner als das Verunreinigungskonzentrationsniveau der zweiten Schicht (24) sind;
die Fotoempfangszone so gebildet ist, daß ihre untere Hauptoberfläche zusammenfallend mit oder über der unteren Hauptoberfläche der dritten Schicht (25) angeordnet ist; und
die Schutzringzone mit solch einer Tiefe gebildet ist, daß sich die Schutzringzone wenigstens in die zweite, mittlere Schicht (24) erstreckt und eine untere Grenze der Schutzringzone unter der oberen Hauptoberfläche der genannten zweiten, mittleren Schicht (24) angeordnet ist.

2. Eine Lawinen-Fotodiode nach Anspruch 1, dadurch gekennzeichnet, daß das genannte Verbindungshalbleitermaterial der ersten Gruppe III-V InGaAs umfaßt und das genannte Verbindungshalbleitermaterial der zweiten Gruppe III-V InP umfaßt.

3. Eine Lawinen-Fotodiode nach Anspruch 1, dadurch gekennzeichnet, daß die genannte zweite, mittlere Schicht (24) der zweiten Halbleiterschicht das Verunreinigungskonzentrationsniveau von etwa 5 x 10¹⁶cm⁻³ oder mehr hat.

4. Eine Lawinen-Fotodiode nach Anspruch 1, dadurch gekennzeichnet, daß die genannte erste, untere Schicht (32) der zweiten Halbleiterschicht das Verunreinigungskonzentrationsniveau von etwa 5 x 10¹⁵cm⁻³ hat.

5. Eine Lawinen-Fotodiode nach Anspruch 1, dadurch gekennzeichnet, daß die genannte untere Grenze der Schutzringzone (27) die untere Hauptoberfläche der zweiten, mittleren Schicht (24) erreicht.

6. Eine Lawinen-Fotodiode nach Anspruch 1, dadurch gekennzeichnet, daß sich die genannte Schutzringzone (27) hin zu der unteren Hauptoberfläche der zweiten, mittleren Schicht der zweiten Halbleiterschicht erstreckt, so daß der Abstand (d) zwischen der unteren Grenze der Schutzringzone und der unteren Hauptoberfläche der zweiten, mittleren Schicht (24) etwa 0,2 µm oder weniger beträgt.

7. Eine Lawinen-Fotodiode nach Anspruch 1, dadurch gekennzeichnet, daß sich die genannte Schutzringzone (27) hin zu der unteren Hauptoberfläche der zweiten, mittleren Schicht (24) der zweiten Halbleiterschicht erstreckt und von ihr in einem Abstand (d) so angeordnet ist, daß die Schutzringzone eine Durchbruchspannung hat, die höher als die Durchbruchspannung (V_{B}) der Fotoempfangszone (26) ist.

## Revendications

1. Photodiode par avalanche pour détecter un rayonnement optique, comprenant :
un substrat (21) en un premier matériau semiconducteur comportant une surface principale supérieure et une surface principale inférieure ;
une première couche semiconductrice (22) comportant une surface principale supérieure et une surface principale inférieure, laquelle est prévue sur la surface principale supérieure du substrat, ladite première couche semiconductrice comportant un premier matériau semiconduteur composite du groupe III-V dopé selon un premier type de conductivité et présentant une largeur de bande interdite correspondant à une longueur d'onde du rayonnement optique qui doit être détecté, ladite première couche semiconductrice produisant des porteurs en réponse au rayonnement optique qui arrive en incidence sur la photodiode par avalanche ;
une seconde couche semiconductrice (24, 25, 32) comportant une surface principale supérieure et une surface principale inférieure, laquelle couche est prévue sur la surface principale supérieure de la première couche semiconductrice, ladite seconde couche semiconductrice comprenant un second matériau semiconducteur composite du groupe III-V dopé selon le premier type de conductivité et présentant une largeur de bande interdite sensiblement supérieure à la largeur de bande interdite de la première couche semiconductrice, ladite seconde couche semiconductrice se voyant appliquer les porteurs produits dans la première couche semiconductrice pour provoquer une multiplication par avalanche des porteurs ;
une région de photoréception dopée (26) du second type de conductivité formée dans la seconde couche semiconductrice et s'étendant depuis la surface principale supérieure de la seconde couche semiconductrice dans ladite couche de telle sorte que sa surface principale inférieure soit positionnée au-dessus de la surface principale inférieure de la seconde couche semiconductrice, ladite région de photoréception transmettant le faisceau optique qui arrive en incidence sur la photodiode par avalanche, ladite surface principale inférieure de la région de photoréception formant une jonction P-N entre la région de photoréception et la seconde couche semiconductrice située au-dessous ;
une région d'anneau de garde dopée (27) du second type de conductivité s'étendant depuis la surface principale supérieure de la seconde couche semiconductrice le long d'une frontière latérale de la région de photoréception et en continuation avec à l'intérieur de ladite seconde couche semiconductrice, en direction de la surface principale inférieure de la seconde couche semiconductrice ;
une première électrode (29) prévue sur la surface principale supérieure de la région d'anneau de garde pour établir un contact électrique avec ; et
une seconde électrode (30) prévue sur la surface principale inférieure du substrat pour établir un contact électrique avec ;
lesdites première et seconde électrodes étant adaptées pour appliquer une tension de polarisation inverse à ladite jonction P-N formée au niveau de la surface principale inférieure de la région de photoréception et pour en outre collecter les porteurs qui sont formés en réponse au rayonnement optique et à la multiplication par avalanche,
caractérisée en ce que ladite seconde couche semiconductrice est formée en tant qu'empilement comportant une première couche inférieure (32), une seconde couche intermédiaire (24) et une troisième couche supérieure (25), lesdites première, seconde et troisième couches présentant des niveaux de concentration en impuretés respectifs qui sont tels que les niveaux de concentration en impuretés de la première couche (32) et de la troisième couche (25) soient sensiblement inférieurs au niveau de concentration en impuretés de la seconde couche (24) ;
la région de photoréception est formée de telle sorte que sa surface principale inférieure soit positionnée de manière à coïncider avec la surface principale inférieure de la troisième couche (25) ou de manière à être au-dessus ; et
la région d'anneau de garde est formée selon une profondeur telle que la région d'anneau de garde s'étende au moins à l'intérieur de la seconde couche intermédiaire (24) et de telle sorte qu'une frontière inférieure de la région d'anneau de garde soit située au-dessous de la surface principale supérieure de ladite seconde couche intermédiaire (24).

2. Photodiode par avalanche selon la revendication 1, caractérisée en ce que ledit premier matériau semiconducteur composite du groupe III-V comprend de l'InGaAs et ledit second matériau semiconducteur composite du groupe III-V comprend de l'InP.

3. Photodiode par avalanche selon la revendication 1, caractérisée en ce que ladite seconde couche intermédiaire (24) de ladite seconde couche semiconductrice présente un niveau de concentration en impuretés d'environ 5 x 10¹⁶ cm⁻³ ou plus.

4. Photodiode par avalanche selon la revendication 1, caractérisée en ce que ladite première couche inférieure (32) de la seconde couche semiconductrice présente un niveau de concentration en impuretés d'environ 5 x 10¹⁵ cm⁻³.

5. Photodiode par avalanche selon la revendication 1, caractérisée en ce que ladite frontière inférieure de la région d'anneau de garde (27) atteint la surface principale inférieure de la seconde couche intermédiaire (24).

6. Photodiode par avalanche selon la revendication 1, caractérisée en ce que ladite région d'anneau de garde (27) s'étend en direction de la surface principale inférieure de la seconde couche intermédiaire de la seconde couche semiconductrice de telle sorte que la séparation (d) entre la frontière inférieure de la région d'anneau de garde et la surface principale inférieure de la seconde couche intermédiaire (24) soit égale à environ 0,2 µm ou moins.

7. Photodiode par avalanche selon la revendication 1, caractérisée en ce que ladite région d'anneau de garde (27) s'étend en direction de la surface principale inférieure de la seconde couche intermédiaire (24) de la seconde couche semiconductrice et en est espacée d'une distance (d) qui est telle que la région d'anneau de garde présente une tension de claquage qui est supérieure à la tension de claquage (V_{B}) de la région de photoréception (26).
